# EUROPEAN PATENT SPECIFICATION

(11) **EP 4 520 715 B1**
(45) Date of publication and mention of the grant of the patent: **27.05.2026**
(21) Application number: 24195113.6
(22) Date of filing: 19.08.2024
(51) Int. Cl.: B81B 7/00

(54) **MEMS DEVICE WITH COMPENSATION OF THE MECHANICAL STRESS AND RELATED MANUFACTURING PROCESS**
MEMS-VORRICHTUNG MIT KOMPENSATION DER MECHANISCHEN BELASTUNG UND ZUGEHÖRIGES HERSTELLUNGSVERFAHREN
DISPOSITIF MEMS AVEC COMPENSATION DE CONTRAINTE MÉCANIQUE ET PROCÉDÉ DE FABRICATION ASSOCIÉ

(30) Priority: 08.09.2023 IT 202300018465
(43) Date of publication of application: 12.03.2025
(73) Proprietor: STMicroelectronics International N.V., 1228 Plan-les-Ouates, Geneva (CH)
(72) Inventor: NICOLI, Silvia, 20836 BRIOSCO (MB) (IT); VARISCO, Igor, 20019 SETTIMO MILANESE (MI) (IT); DANIELE, Filippo, 20149 MILANO (IT); TENTORI, Lorenzo, 20843 VERANO BRIANZA (MB) (IT); D'ERCOLI, Filippo, 20141 MILANO (IT); CAPRA, Federica, 29013 CARPANETO PIACENTINO (PC) (IT)
(74) Representative: Studio Torta S.p.A.

(56) References cited:
- WO-A2-2010/061364

## Description

### Technical Field

The present invention relates to a micro-electromechanical (MEMS) device with compensation of the mechanical stress and to the related manufacturing process.

### Background

As is known, nowadays MEMS devices that envisage the presence of a cantilever are very widespread.

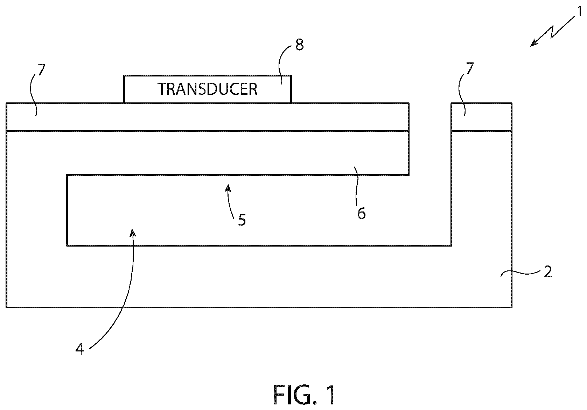

For example, Figure 1 shows a MEMS device 1 which includes a respective semiconductor body 2, having a cavity 4 extending therewithin. Furthermore, the MEMS device 1 comprises a cantilever 5, which has an end integral with the semiconductor body 2 and includes a respective semiconductive portion 6. An oxide layer 7, which is typically formed by thermal oxide, extends above the semiconductor body 2 and the semiconductive portion 6; furthermore, a transducer 8, which is for example a pressure transducer, extends above the portion of oxide layer 7 that overlies the semiconductive portion 6 and, although not shown, may include, inter alia, a pressure deformable membrane, which is coupled to the cantilever 5 so as to form a corresponding sensing cavity, and corresponding electrodes.

In practice, the fact of arranging the transducer 8 above the cantilever 5 allows reducing the impact on the transducer 8 of the residual mechanical stresses which generate during the packaging process of the MEMS device 1 or which generate during the step of soldering the package. However, due to the compressive behavior of the oxide layer 7, the cantilever 5 tends to bend downwards, i.e. towards the cavity 4, as qualitatively shown in Figure 1. This deformation of the cantilever 5 is undesired, since it may cause generation of an offset in the transducer 8 and may also lead the non-constrained end of the cantilever 5 to contact the bottom of the cavity 4, in which case the (undesired) stiction of the non-constrained end of the cantilever 5 to the bottom of the cavity 4 may occur.

In general, the deformation of the cantilever 5 and the resulting drawbacks may also occur in case, above the semiconductive portion 6 of the cantilever 5, a set of layers is present including at least one layer with compressive behavior, not necessarily in direct contact with the semiconductive portion 6 of the cantilever 5.

WO 2010/061364 A2 discloses a MEMS device according to the preamble of claim 1.

### Summary

The aim of the present invention is therefore to provide a MEMS device which at least partially overcomes the drawbacks of the prior art.

According to the present invention, a MEMS device and a manufacturing process are provided, as defined in the attached claims.

### Brief Description of the Figures

For a better understanding of the present invention, embodiments thereof are now described, purely by way of nonlimiting example, with reference to the attached drawings, wherein:
- Figure 1 schematically shows a cross-section of a MEMS device;
- Figure 2 schematically shows a cross-section of an embodiment of the present MEMS device;
- Figure 3 schematically shows a top view with portions removed of the MEMS device shown in Figure 2;
- Figures 4-9 schematically show cross-sections of the MEMS device shown in Figure 2, during successive steps of a manufacturing process;
- Figures 10-15 schematically show cross-sections of a variation of the MEMS device shown in Figure 2, during successive steps of a manufacturing process;
- Figures 16-17 schematically show cross-sections of a variation of the MEMS device shown in Figure 2, during successive steps of a manufacturing process; and
- Figures 18-21 schematically show cross-sections of a variation of the MEMS device shown in Figure 2, during successive steps of a manufacturing process; and
- Figures 22-23 schematically show cross-sections of a variation of the MEMS device shown in Figure 2, during successive steps of a manufacturing process.

### Description of Embodiments

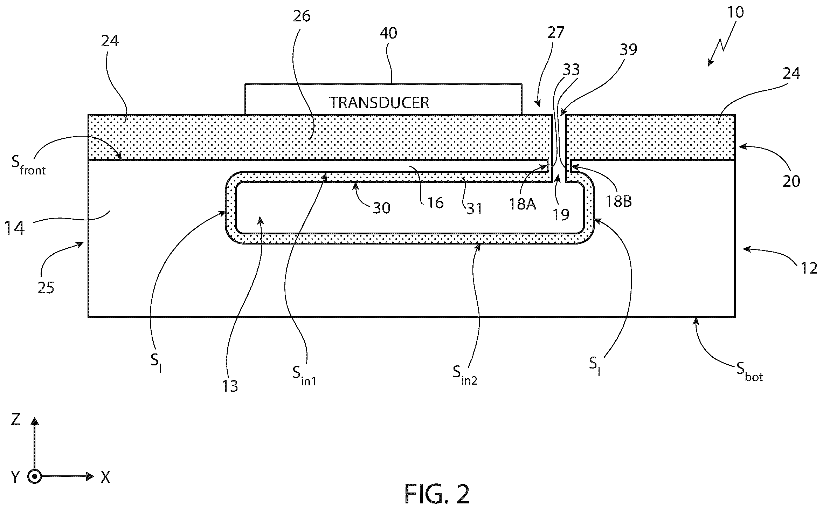

Figure 2 shows an orthogonal reference system XYZ and a MEMS device 10, which comprises a semiconductor body 12, formed for example by silicon.

In a per se known manner, the semiconductor body 12 may comprise for example a semiconductor substrate and one or more epitaxial layers (not shown individually in Figure 2). Furthermore, the semiconductor body 12 is delimited upwardly by a front surface S_{front} and is delimited downwardly by a bottom surface S_{bot}. As a first approximation, the front surface S_{front} and the bottom surface S_{bot} are parallel to the XY plane.

The semiconductor body 12 houses a cavity 13 and forms a fixed semiconductive region 14 and a suspended semiconductive region 16, which extends cantilevered from the fixed semiconductive region 14. In particular, the fixed semiconductive region 14 delimits the cavity 13 downwardly and laterally; the suspended semiconductive region 16 delimits the cavity 13 upwardly.

In greater detail, the fixed semiconductive region 14 and the suspended semiconductive region 16 are delimited upwardly by the front surface S_{front}. The suspended semiconductive region 16 has a first end, which is fixed to the fixed semiconductive region 14, and a second end, which is free; furthermore, the suspended semiconductive region 16 is delimited downwardly by a first internal surface Sᵢₙ₁, which delimits the cavity 13 upwardly. Furthermore, the cavity 13 is delimited laterally by a lateral surface Sₗ and is delimited downwardly by a second internal surface Sᵢₙ₂, which are formed by the fixed semiconductive region 14.

In even greater detail, the suspended semiconductive region 16 is delimited laterally by a first trench portion 19, which faces, upwardly, the front surface S_{front} and also faces, downwardly, the first internal surface Sᵢₙ₁, so as to communicate with the underlying cavity 13.

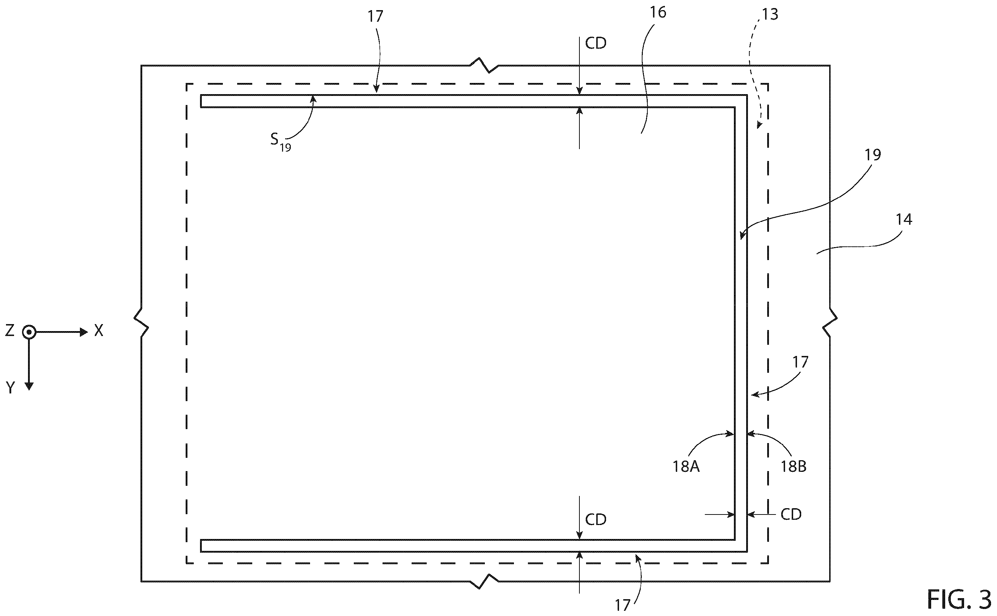

As shown in Figure 3, wherein the cavity 13 is shown with a dashed line, in top view the first trench portion 19 has an elongated shape, for example a 'C' shape, with approximately constant width. Consequently, the first trench portion 19 is delimited laterally by three pairs 17 of lateral walls, which define a lateral trench surface S₁₉. In particular, each pair 17 of lateral walls comprises a respective first wall, formed by the suspended semiconductive region 16, and a respective second wall, formed by the fixed semiconductive region 14 and facing the corresponding first wall, the first and the second walls being approximately parallel to each other and spaced by a distance CD, as visible in Figure 3, wherein for brevity only the first and the second walls arranged parallel to the XY plane have been indicated (by 18A and 18B, respectively). As a first approximation, the distance CD is the same for the three pairs 17 of lateral walls and may for example be comprised in the range 0.2µm - 2µm (boundaries included); however, the distance CD may also be variable according to the pair of lateral walls.

The MEMS device 10 further comprises a front dielectric layer 20, which is formed by thermal oxide and extends above the front surface S_{front}. In particular, the front dielectric layer 20 includes a first portion 24, which overlies the fixed semiconductive region 14, in direct contact, and a second portion 26, which overlies the suspended semiconductive region 16, in direct contact. The first and the second portions 24, 26 are separated by a second trench portion 39, which extends through the front dielectric layer 20 and communicates with the underlying first trench portion 19, forming a single trench therewith; as a first approximation, in top view the second trench portion 39 may have the same 'C' shape as the first trench portion 19, in such a way that the aforementioned trench also has approximatively a 'C' shape.

Purely by way of example, the front dielectric layer 20 may have a thickness comprised in the range 0.5µm - 3.2µm (boundaries included).

In practice, the first portion 24 of the front dielectric layer 20 and the fixed semiconductive region 14 form a fixed structure 25; the second portion 26 of the front dielectric layer 20 and the suspended semiconductive region 16 form a suspended structure 27, which is delimited laterally by the first and the second trench portions 19, 39 and extends cantilevered from the fixed structure 25, being fixed thereto, so as to overlay the cavity 13.

The MEMS device 10 further comprises an internal dielectric layer 30, which conformally coats the cavity 13, therefore coating the cavity 13 without filling it. In particular, the internal dielectric layer 30 coats the lateral surface Sₗ and the first and the second internal surfaces Sᵢₙ₁, Sᵢₙ₂. In the following, reference is made to the compensation portion 31 to indicate the portion of the internal dielectric layer 30 which coats the first internal surface Sᵢₙ₁. The compensation portion 31 also forms the suspended structure 27; furthermore, the compensation portion 31 is a mechanical tension compensation portion.

As explained in greater detail below, as a first approximation the internal dielectric layer 30 has a thickness equal to half the distance CD.

Furthermore, the MEMS device 10 comprises a coating region 33, which is formed by thermal oxide and coats the lateral trench surface S₁₉, so as to contact upwardly and downwardly, respectively, with the front dielectric layer 20 and the internal dielectric layer 30, forming a single thermal oxide region therewith.

The MEMS device 10 further comprises a transducer 40, which is arranged above the second portion 26 of the front dielectric layer 20.

Purely by way of example, the transducer 40 is a capacitive pressure transducer and, although not shown, includes a respective pressure deformable membrane and respective electrodes, in such a way that, in use, the transducer 40 is configured to generate an electrical signal indicative of pressure. In any case, the type of transducer is irrelevant for the purposes of the present invention.

In practice, the suspended semiconductive region 16 is interposed between the second portion 26 of the front dielectric layer 20 and the compensation portion 31 of the internal dielectric layer 30, which, as explained, are both formed by thermal oxide and, therefore, have a same compressive behavior. Therefore, since the second portion 26 of the front dielectric layer 20 and the compensation portion 31 of the internal dielectric layer 30 extend on opposite faces of the suspended semiconductive region 16, a compensation of the tensions which act on the suspended semiconductive region 16 is obtained, reducing the deformation of the suspended semiconductive region 16 and, more generally, of the suspended structure 27. In this manner, possible offsets that might affect the transducer 40, in case the suspended structure 27 were bent, are reduced.

The MEMS device 10 may be manufactured by the manufacturing process described hereinbelow, from a semiconductive wafer 100, which is intended to form the semiconductor body 12 and is delimited by the front surface S_{front} and the bottom surface S_{bot}.

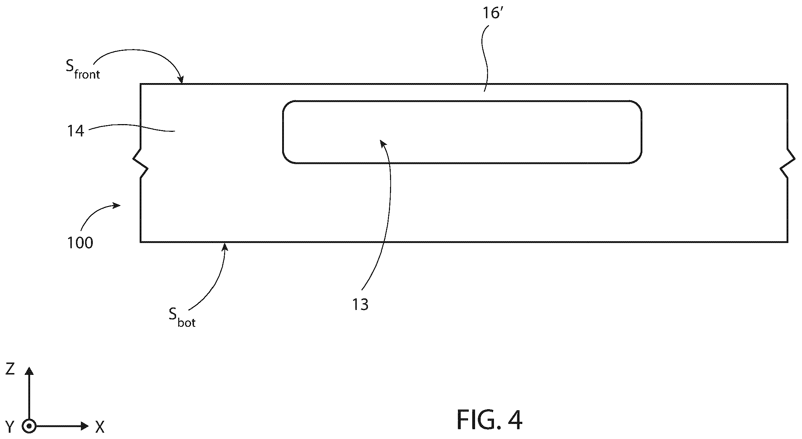

Initially, as shown in Figure 4, the cavity 13 is formed, in a per se known manner. In particular, initially the cavity 13 is of buried type, therefore it extends at a distance from the front surface S_{front} and from the bottom surface S_{bot}. In this manner, the semiconductive wafer 100 forms the fixed semiconductive region 14 and a temporary semiconductive region 16', which closes the cavity 13 upwardly and is intended to form the suspended semiconductive region 16.

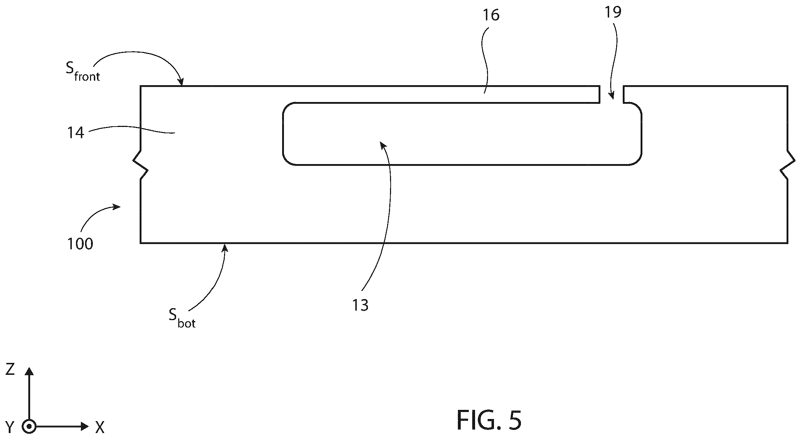

Subsequently, as shown in Figure 5, an etching process (for example, of dry or wet type) is performed, so as to selectively remove a portion of the temporary semiconductive region 16' and form the first trench portion 19, which communicates with the cavity 13 downwardly. The remaining portion of the temporary semiconductive region 16' forms the suspended semiconductive region 16.

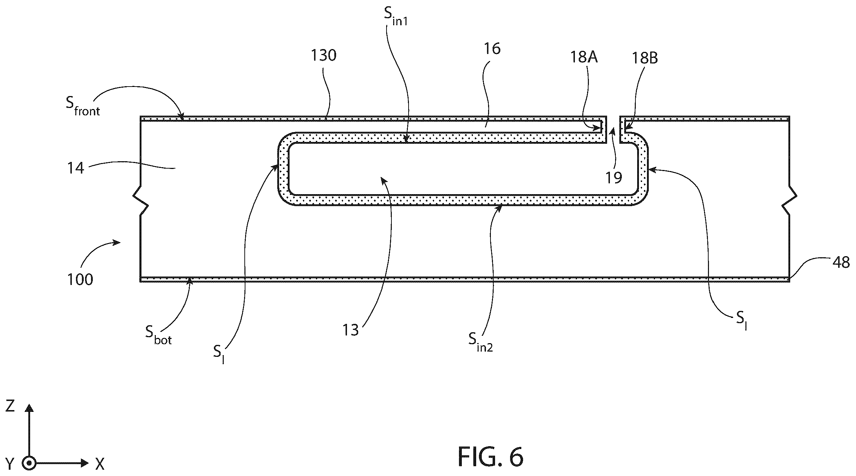

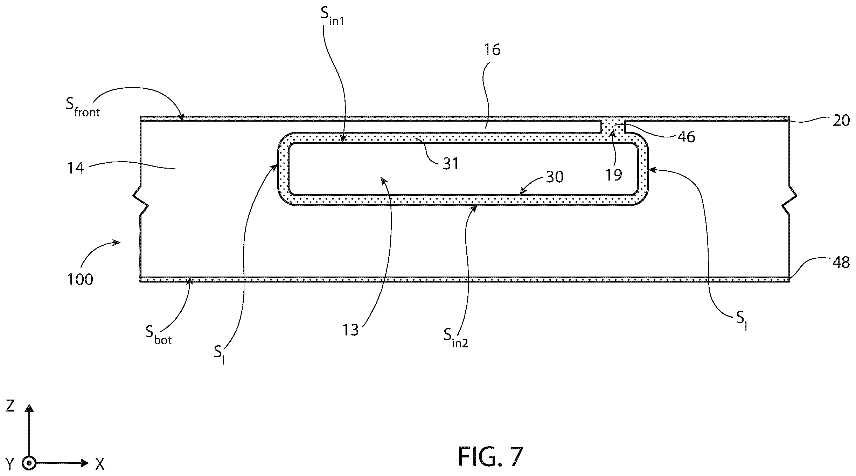

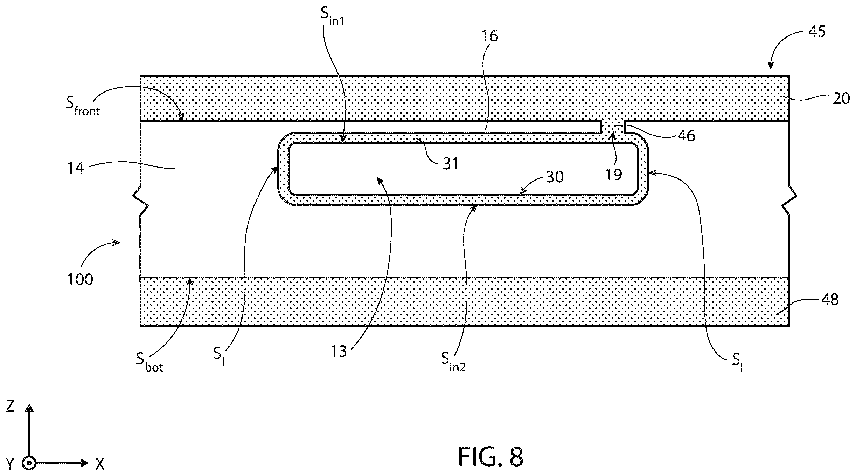

Successively, as shown in Figures 6, 7 and 8, a thermal oxidation process is performed; in particular, Figure 6 refers to an initial step of the thermal oxidation process, while Figure 7 refers to an intermediate step of the thermal oxidation process; Figure 8 refers to a terminal step of the thermal oxidation process. For simplicity it is assumed that, as a first approximation, the shape of the first trench portion 19 does not change during the thermal oxidation process, i.e. the changes in the shape of the first trench portion 19 (in particular, the modifications of the lateral walls) caused by this oxidation are neglected.

In greater detail, as shown in Figure 6, initially the manufacturing process causes the formation of a preliminary layer 130 of thermal oxide, which coats the lateral surface Sₗ and the first and the second internal surfaces Sᵢₙ₁, Sᵢₙ₂ of the cavity 13, and the front surface S_{front}; furthermore, the preliminary layer 130 coats the lateral trench surface S₁₉, i.e. the pairs 17 of lateral walls of the first trench portion 19, without completely filling the first trench portion 19, i.e. without closing the first trench portion 19, which forms an opening arranged facing the cavity 13. The preliminary layer 130 has a substantially uniform thickness, which increases over time. In fact, the portions of preliminary layer 130 that coat the front surface S_{front} and the pairs 17 of lateral walls of the first trench portion 19 are exposed to the reagent used in the thermal oxidation process, therefore they gradually increase in thickness; furthermore, since the first trench portion 19 is not closed, the reagent may continue to enter the cavity 13, allowing the gradual increase in thickness also of the portions of the preliminary layer 130 that coat the lateral surface Sₗ and the first and the second internal surfaces Sᵢₙ₁, Sᵢₙ₂ of the cavity 13.

When the thickness of the preliminary layer 130 becomes approximately equal to half the distance CD, it occurs that, as shown in Figure 7, the portions of preliminary layer 130 that coat the pairs 17 of lateral walls of the first trench portion 19 obstruct the first trench portion 19, sealing the cavity 13. Since the reagent can no longer access the cavity 13, the thermal oxidation process, and therefore the increase in thickness of the preliminary layer 130, stops within the cavity 13, while continues outside, and in particular, above the front surface S_{front}. In these conditions, the portions of preliminary layer 130 that coat the lateral surface S₁ and the first and the second internal surfaces Sᵢₙ₁, Sᵢₙ₂ of the cavity 13 form the internal dielectric layer 30; the portions of preliminary layer 130 that coat the front surface S_{front} form the front dielectric layer 20; furthermore, the portions of preliminary layer 130 that coat the pairs 17 of lateral walls of the first trench portion 19 form a top closing region 46, which precisely fills the first trench portion 19, sealing it.

Successively, the thermal oxidation process continues, above the front surface S_{front}, with a resulting increase in thickness of the front dielectric layer 20, as shown in Figure 8. Conversely, the internal dielectric layer 30 does not undergo modifications.

In practice, at the end of the thermal oxidation process, a dielectric structure 45 of thermal oxide is present, which comprises the front dielectric layer 20, the internal dielectric layer 30 and the top closing region 46. Furthermore, although not previously described, during the thermal oxidation process, a temporary layer 48 of thermal oxide, whose thickness gradually increases over time during the thermal oxidation process, forms below the bottom surface S_{bot}.

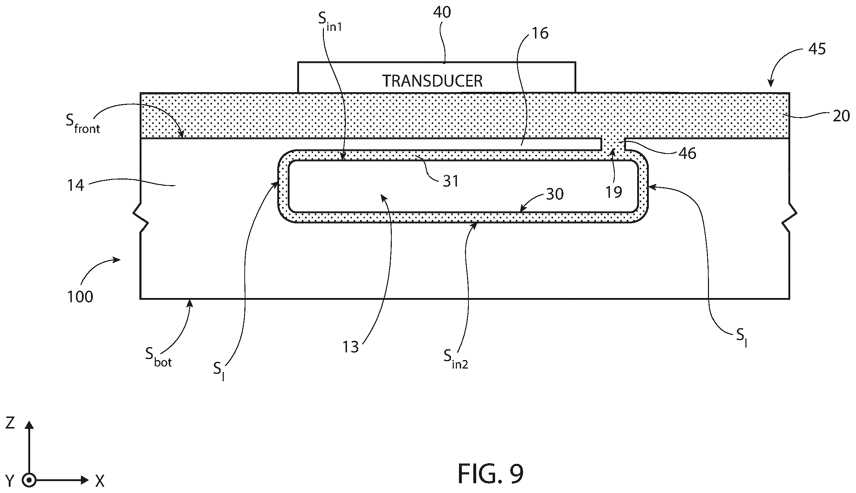

Subsequently, as shown in Figure 9, the temporary layer 48 is removed, in a per se known manner. Furthermore, the transducer 40 is formed in a per se known manner; forming the transducer 40 may include forming further regions/layers, not shown.

Finally, to obtain the MEMS device 10 shown in Figure 2, an etching (for example, of wet or dry type) is performed, so as to selectively remove a portion of the front dielectric layer 20 (thus forming the second trench portion 39) and an underlying portion of the top closing region 46, thanks to the use of a mask (not shown). In this manner, the first and the second portions 24, 26 of the front dielectric layer 20 are defined and the release of the suspended structure 27 is obtained. The remaining portion of the top closing region 46 forms the coating region 33. Although not shown, however, variations (not shown) are possible, wherein the mask is such that the top closing region 46 is entirely removed, so as to expose the pairs 17 of lateral walls of the trench 19; in this case, the etching process is defined by the trench 19.

The manufacturing process may therefore proceed in a per se known manner, for example by performing dicing operations on the semiconductive wafer 100, which are not further described.

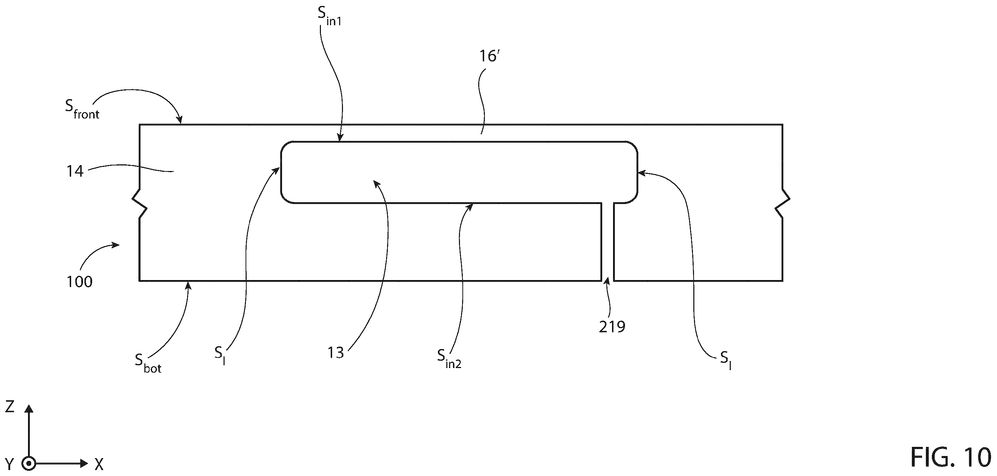

According to a variation of the manufacturing process, following the formation of the cavity 13, of buried type and delimited upwardly by the temporary semiconductive region 16', a hole 219 is formed, as shown in Figure 10. Purely by way of example, the hole 219 may have a cylindrical section and extends vertically between the second internal surface Sᵢₙ₂ and the bottom surface S_{bot}.

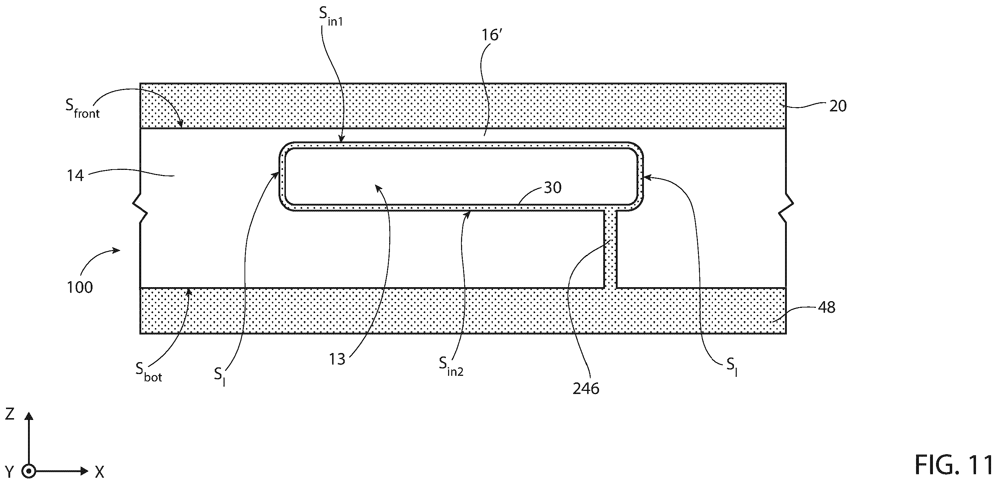

Subsequently, as shown in Figure 11, a thermal oxidation process is performed, in the same manner as described with reference to Figures 6-8, in such a way as to form the internal dielectric layer 30 and a bottom closing region 246, which is formed by thermal oxide and fills the hole 219, so as to seal the cavity 13. Although not shown in detail, even in this case the thermal oxidation process causes the formation, within the cavity 13 and the hole 219, of a thermal oxide preliminary layer, whose thickness increases over time, up to obstructing the hole 219; the closing of the hole 219 occurs before the end of the thermal oxidation process. Consequently, the thickness of the internal dielectric layer 30 depends on the shape of the hole 219; for example, in case the hole 219 has an invariant section for translations parallel to the Z-axis, the thickness of the internal dielectric layer 30 depends on the shape of the section of the hole 219.

During the thermal oxidation process, the formation of the front dielectric layer 20 and the temporary layer 48 also occurs.

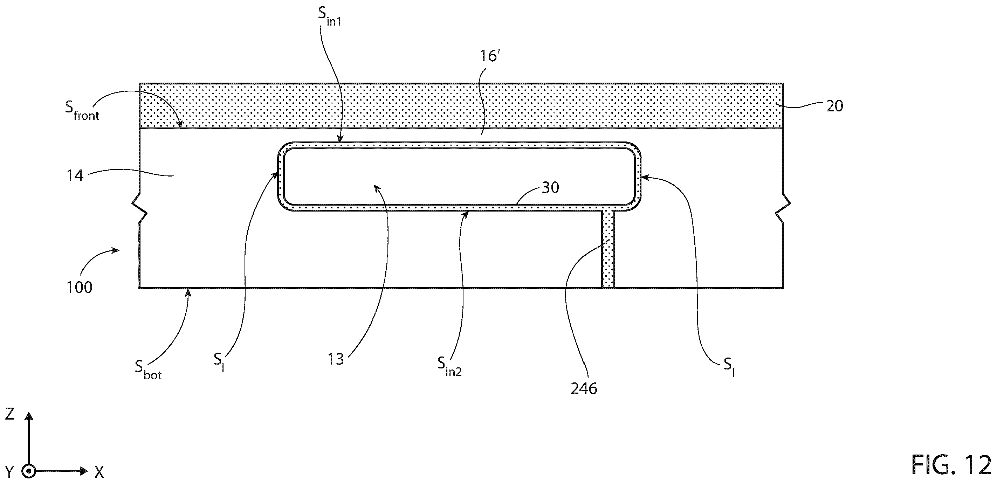

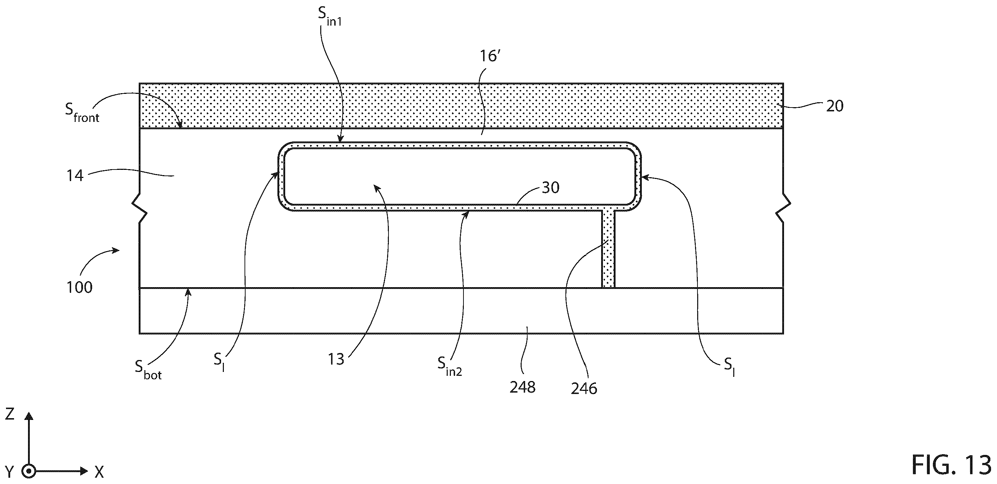

Subsequently, as shown in Figure 12, the temporary layer 48 is removed. Successively, optionally, an epitaxial growth of semiconductor material may be carried out from the bottom surface S_{bot}, as shown in Figure 13. In this manner, a bottom epitaxial region 248 of semiconductor material, which allows the thickness of the semiconductive wafer 100 to be increased, if desired, is formed below the bottom surface S_{bot}; in any case, the bottom epitaxial region 248 is optional.

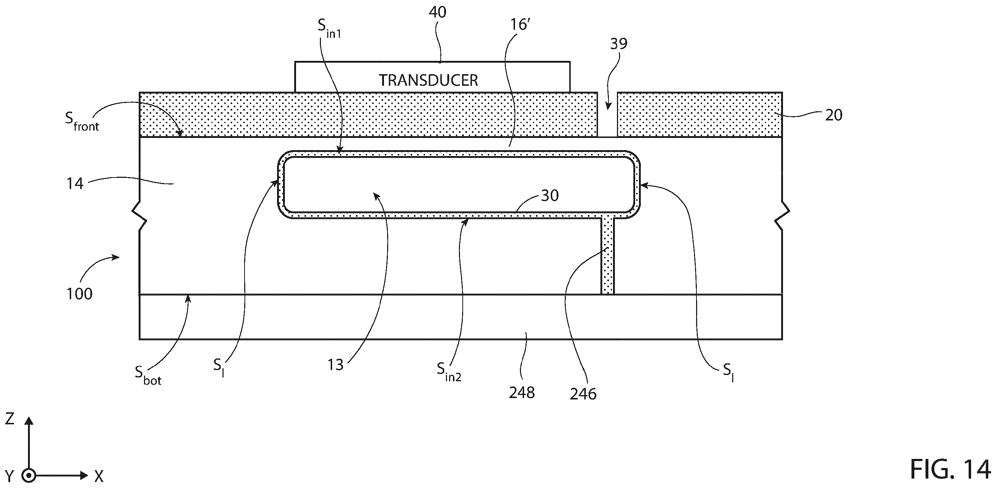

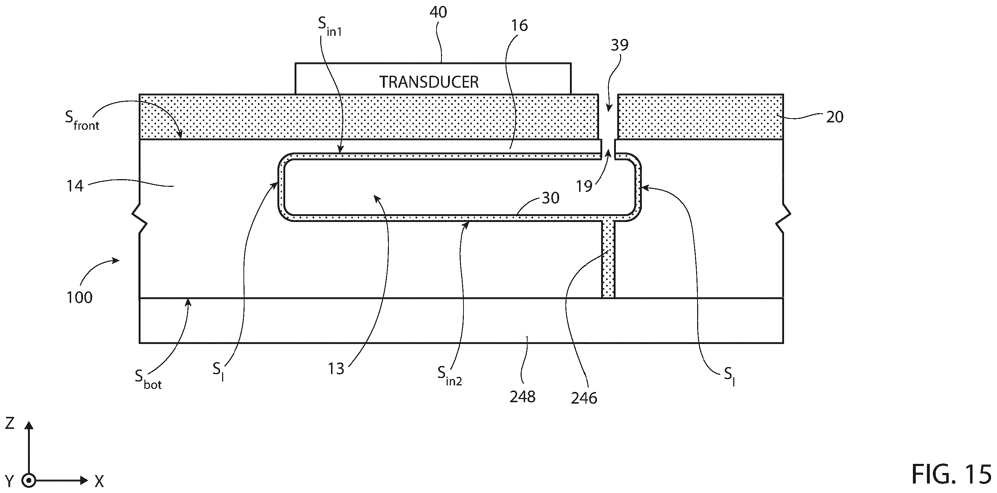

Subsequently, the manufacturing process proceeds with the formation of the transducer 40 on a portion of the front dielectric layer 20 that overlies the temporary semiconductive region 16' and a successive etching process, which selectively removes a portion of the top dielectric layer 20, so as to form the second trench portion 39 and expose a part of the temporary semiconductive region 16', as shown in Figure 14. Subsequently, an etching process (for example, of dry or wet type) is performed to selectively remove a portion of the exposed part of the temporary semiconductive region 16', so as to form the first trench portion 19, and a part of the internal dielectric layer 30 that extends below the first trench portion 19, so as to release the suspended structure 27, as shown in Figure 15. In this case, the coating region 33 is absent.

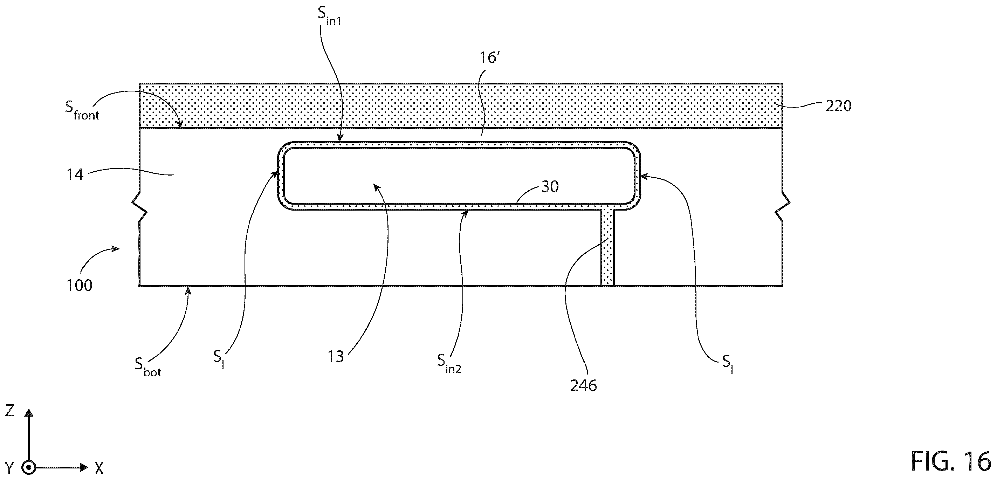

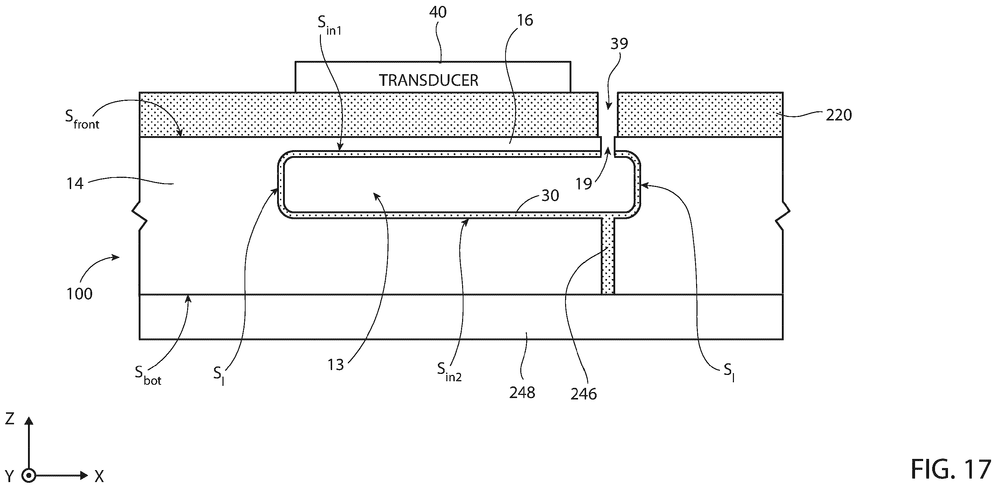

According to a variation, following the operations shown in Figure 12, the front dielectric layer 20 may be removed and successively an alternative dielectric layer 220, formed for example of silicon nitride, may be formed above the front surface S_{front}, as shown in Figure 16. In this case, the manufacturing process may then proceed as described with reference to Figures 13-15, but the transducer 40 is formed on the alternative dielectric layer 220, as shown in Figure 17.

The alternative dielectric layer 220 has a tensile behavior, therefore it would per se tend to cause the suspended structure 27 to bend upwards. However, the transducer 40 may include one or more respective layers (not shown) with compressive behavior; consequently, the compensation portion 31 of the internal dielectric layer 30 may be sized so as to compensate the overall behavior of the layers present above the suspended semiconductive region 16, including any layers that form the transducer 40 and are not in direct contact with the suspended semiconductive region 16.

In general, even in the case of the manufacturing process described with reference to Figures 4-9, in lieu of the front dielectric layer 20 or above the front dielectric layer 20, a layer (not shown) formed by a dielectric different from thermal oxide, which may have tensile behavior, may be present.

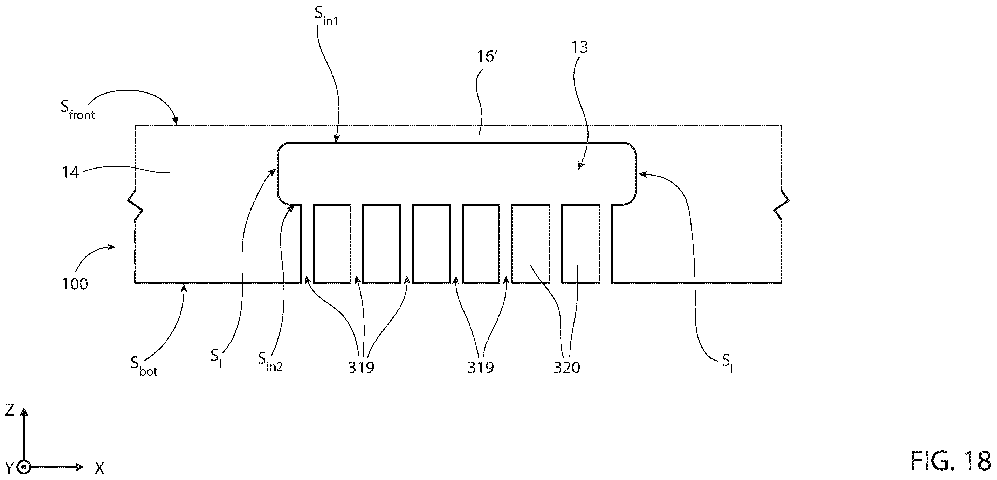

According to a further variation, the manufacturing process envisages, after forming the cavity 13 of buried type, forming a plurality of holes 319, which extend between the second internal surface Sᵢₙ₂ and the bottom surface S_{bot}, as shown in Figure 18. Pairs of adjacent holes 319 laterally delimit corresponding semiconductive pillars 320.

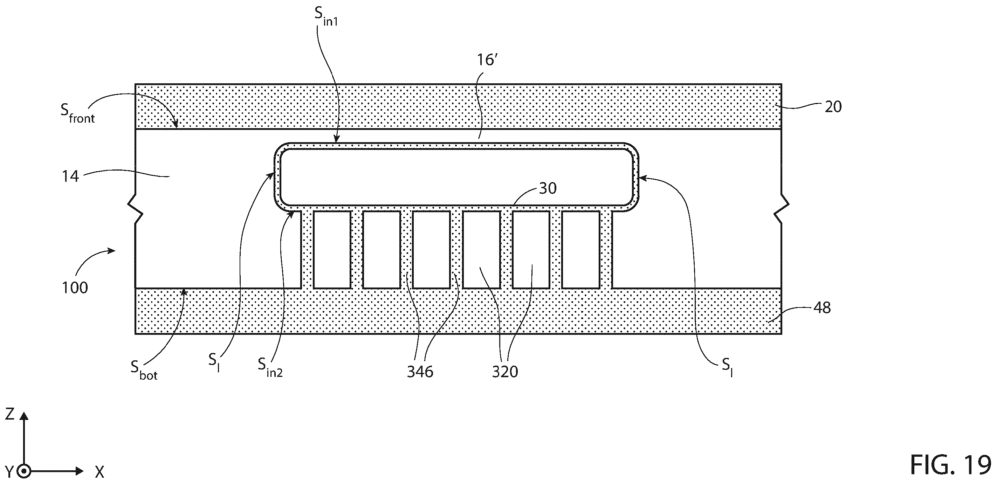

Subsequently, as shown in Figure 19, a thermal oxidation process is performed, as already described with reference to Figure 11. In this manner, the internal dielectric layer 30 and a plurality of bottom closing regions 346 are formed. Each bottom closing region 346 is formed by thermal oxide and fills a corresponding hole 319. The cavity 13 is thus sealed. The thermal oxidation process also causes the formation of the front dielectric layer 20 and the temporary layer 48.

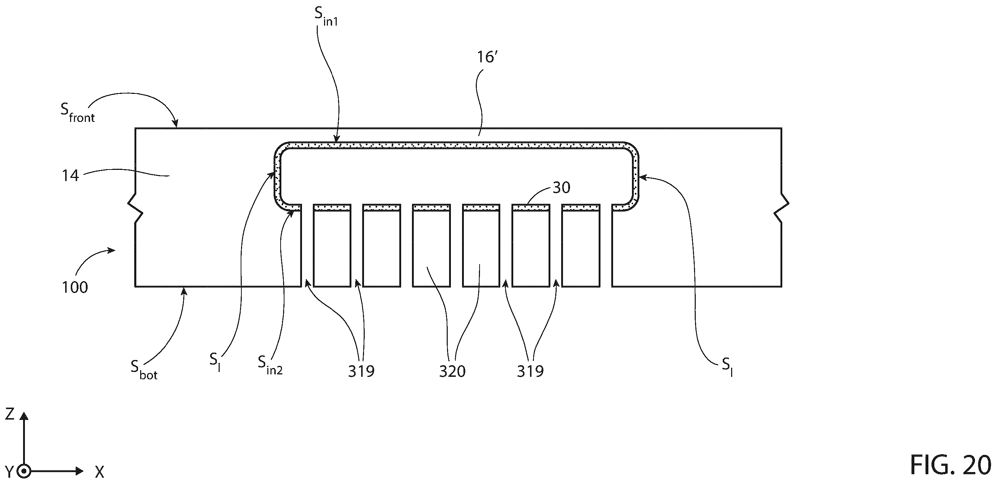

Subsequently, as shown in Figure 20, the front dielectric layer 20, the temporary layer 48 and the bottom closing regions 346 are removed. In practice, the holes 319 are opened again and also extend through the portion of internal dielectric layer 30 that coats the second internal surface Sᵢₙ₂, forming corresponding openings of the cavity 13.

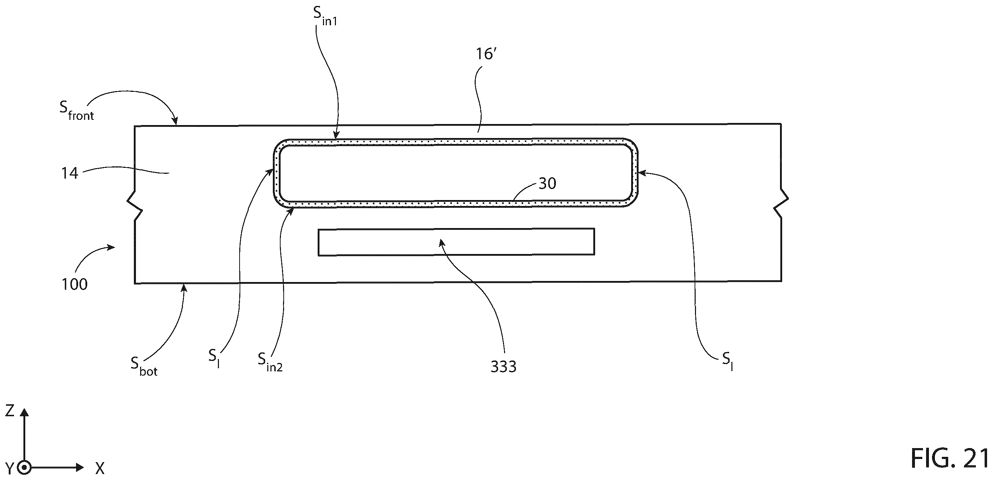

Successively, as shown in Figure 21, a thermal treatment is performed in a hydrogen (H₂) environment, which causes a redistribution of the material which forms the semiconductive pillars 320, in such a way that the openings of the cavity 13 close and the internal dielectric layer 30 completely coats again the second internal surface Sᵢₙ₂; furthermore, between the cavity 13 and the bottom surface S_{bot} an additional cavity 333, of buried type, is formed which, purely by way of example, may allow for example a differential-type pressure transduction to be carried out.

Subsequently, the manufacturing process may continue for example as described with reference to Figure 16, therefore with the formation of the alternative dielectric layer 220 and with the subsequent operations previously described, but without forming the bottom epitaxial region 248. Furthermore, in case (not shown), after the operations shown in Figure 19, only the temporary layer 48 and the bottom closing regions 346 were removed (i.e., leaving the front dielectric layer 20), the manufacturing process might proceed as described with reference to Figures 14 and 15.

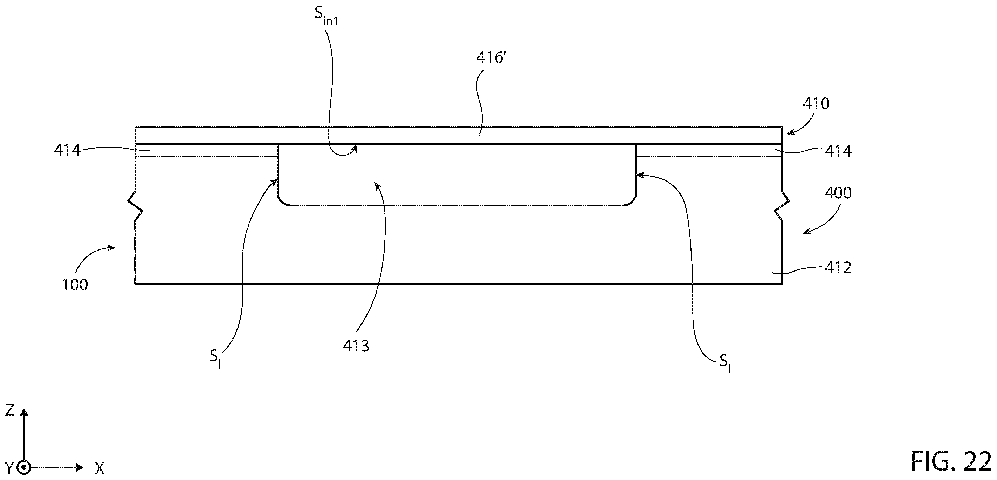

According to a further variation of the manufacturing process, as shown in Figure 22, the cavity (here indicated by 413) may be formed in a "silicon-on-insulator" structure 400, which includes a top semiconductive substrate 410 and a bottom semiconductive substrate 412, which are formed for example by silicon and are coupled by interposition of an insulating layer 414 of silicon oxide. In this case, the cavity 413 is delimited upwardly by a part 416' of the top semiconductive substrate 410, which is delimited downwardly by the first internal surface Sᵢₙ₁; the second internal surface Sᵢₙ₂ is formed by the bottom semiconductive substrate 412. Furthermore, a top portion of the lateral surface S₁ is formed by the insulating layer 414; a bottom portion of the lateral surface S₁ is formed by the bottom semiconductive substrate 412.

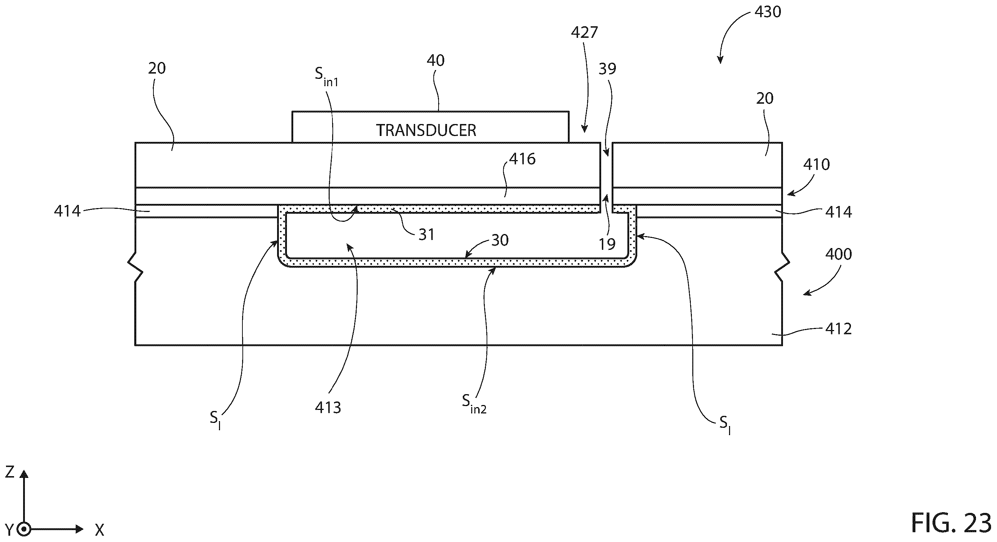

In this case, the manufacturing process may proceed as described with reference to Figures 5-9; the part 416' of the top semiconductive substrate 410 performs the function previously performed by the temporary semiconductive region 16'. In this manner, the MEMS device 430 shown in Figure 23 is obtained, wherein the front dielectric layer (indicated again by 20 and traversed by the second trench portion 39) extends on the top semiconductive substrate 410; the first trench portion (indicated again by 19) extends through the top semiconductive substrate 410 and delimits the suspended semiconductive region (here indicated by 416), which is formed by a residual portion of the part 416' of the top semiconductive substrate 410; the internal dielectric layer (indicated again by 30) coats the cavity 413; the compensation portion (indicated again by 31) extends below the suspended semiconductive region 416. The suspended structure (here indicated by 427) is formed by the suspended semiconductive region 416, the compensation portion 31 and the portion of front dielectric layer 20 overlying the suspended semiconductive region 416.

The advantages that the present solution affords are clear from the preceding description.

In particular, the present solution allows reducing the bending of the suspended structure which extends cantilevered and supports the transducer, resulting in performance improvement of the latter. Furthermore, the present solution allows setting the thickness of the thermal oxide region which extends below the suspended semiconductive region, so as to adapt the compressive action of this thermal oxide region as a function of the composition of the layers that extend above the suspended semiconductive region. In this regard, as previously mentioned, the compressive layer arranged above the suspended semiconductive region may form part of the transducer or in any case may not be in direct contact with the suspended semiconductive region.

In addition, the present solution is inexpensive and may be easily integrated into a process flow of a known type.

Finally, it is clear that modifications and variations may be made to the present MEMS device and the manufacturing process, without departing from the scope of the present invention, as defined in the attached claims.

For example, in general the transducer may be of any type. Furthermore, the transducer may be suitable for being controlled (e.g., electrically controlled) in order to transduce a control signal into a corresponding transduced signal (e.g., an acoustic signal).

Furthermore, referring for simplicity to the embodiment shown in Figure 2 (but the same considerations also apply to the other embodiments), the shapes of the first and the second trench portions 19, 39 may vary with respect to what has been described; more generally, the relationship between the thickness of the internal dielectric layer 30 and the shape of the first trench portion 19 may vary with respect to what has been described.

As regards the embodiment shown in Figure 2, the front dielectric layer 20 may be formed by an oxide other than a thermal oxide, such as for example a deposited oxide.

Finally, as previously mentioned, the number and the type of layers arranged above the suspended semiconductive region may differ with respect to what has been described.

## Claims

1. A MEMS device comprising:
- a fixed body (14;400) delimiting a cavity (13;413);
- a suspended structure (27;427) extending cantilevered from the fixed body, above the cavity, and comprising a suspended semiconductive region (16;416); and
- a transducer (40) arranged above the suspended structure;
and wherein the suspended structure further comprises a compensation region (31), which extends below the suspended semiconductive region; the MEMS device (10) being **characterized in that** the compensation region (31) is made of thermal oxide.

2. The MEMS device according to claim 1, further comprising at least one compressive region (20) arranged above the suspended semiconductive region (16;416).

3. The MEMS device according to claim 2, wherein the compressive region (20) comprises a front dielectric layer (20) of thermal oxide, arranged above the suspended semiconductive region (16;416).

4. The MEMS device according to claim 3, wherein the front dielectric layer (20) contacts the suspended semiconductive region (16;416), and wherein the transducer (40) is arranged above the front dielectric layer.

5. The MEMS device according to any of the preceding claims, comprising an internal dielectric layer (30) of thermal oxide, which coats the cavity (13) and forms the compensation region (31).

6. A process for manufacturing a MEMS device (10;430), comprising:
- forming a fixed body (14;400) delimiting a cavity (13;413);
- forming a suspended structure (27;427) extending cantilevered from the fixed body, above the cavity, and comprising a suspended semiconductive region (16;416); and
- forming a transducer (40) arranged above the suspended structure;
and wherein forming the suspended structure comprises forming a compensation region (31), which extends below the suspended semiconductive region; the manufacturing process being **characterized in that** the compensation region (31) is made of thermal oxide.

7. The manufacturing process according to claim 6, comprising forming at least one compressive region (20) arranged above the suspended semiconductive region (16;416).

8. The manufacturing process according to claim 7, wherein forming at least one compressive region (20) comprises forming a front dielectric layer (20) of thermal oxide, arranged above the suspended semiconductive region (16;416).

9. The manufacturing process according to any of claims 6 to 8, wherein forming a fixed body (12) comprises forming a semiconductor body (12) delimited by a front surface (S_{front}) and a bottom surface (S_{bot}); said manufacturing process further comprising:
- forming the cavity (13) so that it is buried into the semiconductor body;
- forming at least one opening (19;219) which extends into the semiconductor body, between the cavity and one of the front surface and the bottom surface; and
- performing a thermal oxidation process, so as to coat the cavity with an internal dielectric layer (30) of thermal oxide, which forms the compensation region (31);
and wherein forming the suspended structure comprises releasing the suspended structure following the formation of the internal dielectric layer.

10. The manufacturing process according to claim 9 when dependent on claim 8, comprising forming the front dielectric layer (20) by said thermal oxidation process.

11. The manufacturing process according to claim 9 or 10, comprising, by the thermal oxidation process:
- increasing the thickness of the internal dielectric layer (30); and
- causing the formation of a closing region (46;246) of thermal oxide which closes the opening (19;219), sealing the cavity (13), so as to stop the increase in thickness of the internal dielectric layer (30) before the end of the thermal oxidation process, in such a way that the thickness of the internal dielectric layer (30) depends on the shape of the opening.

12. The manufacturing process according to any of claims 9 to 11, wherein forming at least one opening (19;219) comprises forming, after forming the cavity (13) and before performing the thermal oxidation process, a plurality of openings (319) which extend between the cavity (13) and the bottom surface (S_{bot}), in such a way that the openings delimit a plurality of pillar semiconductive regions (320); and wherein the execution of the thermal oxidation process causes the formation, in each opening (319), of a corresponding closing region (346) of thermal oxide, so as to seal the cavity; said manufacturing process further comprising:
- selectively removing the closing regions; and
- performing a thermal treatment so as to cause the formation, from the pillar semiconductive regions (320), of an additional cavity (333), which is of buried type and extends between the cavity and the bottom surface (S_{bot}).

13. The manufacturing process according to any of claims 6 to 8, wherein forming a fixed body (12) comprises forming a structure (400) comprising an insulating layer (414) and a top semiconductive substrate (410) and a bottom semiconductive substrate (412), which are coupled by interposition of the insulating layer; said manufacturing process further comprising:
- forming the cavity (413) so that it is delimited upwardly by a part (416') of the top semiconductive substrate and is delimited laterally by portions of the insulating layer and the bottom semiconductive substrate;
- forming a trench (19) which extends through the part of the top semiconductive substrate; and
- performing a thermal oxidation process, so as to coat the cavity with an internal dielectric layer (30) of thermal oxide, which forms the compensation region (31).

## Patentansprüche

1. MEMS-Vorrichtung, die Folgendes umfasst:
- einen feststehenden Körper (14;400), der einen Hohlraum (13;413) begrenzt;
- eine aufgehängte Struktur (27;427), die sich freitragend vom feststehenden Körper oberhalb des Hohlraums erstreckt und einen aufgehängten Halbleiterbereich (16;416) umfasst; und
- einen Wandler (40), der oberhalb der aufgehängten Struktur angeordnet ist;
und wobei die aufgehängte Struktur ferner einen Kompensationsbereich (31) umfasst, der sich unterhalb des aufgehängten Halbleiterbereichs erstreckt; wobei die MEMS-Vorrichtung (10) **dadurch gekennzeichnet ist, dass** der Kompensationsbereich (31) aus thermischem Oxid besteht.

2. MEMS-Vorrichtung nach Anspruch 1, die ferner mindestens einen komprimierenden Bereich (20) umfasst, der oberhalb des aufgehängten Halbleiterbereichs (16;416) angeordnet ist.

3. MEMS-Vorrichtung nach Anspruch 2, wobei der komprimierende Bereich (20) eine vordere dielektrische Schicht (20) aus thermischem Oxid umfasst, die oberhalb des aufgehängten Halbleiterbereichs (16;416) angeordnet ist.

4. MEMS-Vorrichtung nach Anspruch 3, wobei die vordere dielektrische Schicht (20) den aufgehängten Halbleiterbereich (16;416) berührt, und wobei der Wandler (40) oberhalb der vorderen dielektrischen Schicht angeordnet ist.

5. MEMS-Vorrichtung nach einem der vorhergehenden Ansprüche, die eine innere dielektrische Schicht (30) aus thermischem Oxid umfasst, die den Hohlraum (13) beschichtet und den Kompensationsbereich (31) bildet.

6. Verfahren zum Herstellen einer MEMS-Vorrichtung (10;430), das Folgendes umfasst:
- Bilden eines feststehenden Körpers (14;400), der einen Hohlraum (13;413) begrenzt;
- Bilden einer aufgehängten Struktur (27;427), die sich freitragend vom feststehenden Körper oberhalb des Hohlraums erstreckt und einen aufgehängten Halbleiterbereich (16;416) umfasst; und
- Bilden eines Wandlers (40), der oberhalb der aufgehängten Struktur angeordnet ist;
und wobei das Bilden der aufgehängten Struktur das Bilden eines Kompensationsbereichs (31) umfasst, der sich unterhalb des aufgehängten Halbleiterbereichs erstreckt; wobei das Herstellungsverfahren **dadurch gekennzeichnet ist, dass** der Kompensationsbereich (31) aus thermischem Oxid besteht.

7. Herstellungsverfahren nach Anspruch 6, umfassend das Bilden mindestens eines komprimierenden Bereichs (20), der oberhalb des aufgehängten Halbleiterbereichs (16;416) angeordnet ist.

8. Herstellungsverfahren nach Anspruch 7, wobei das Bilden mindestens eines komprimierenden Bereichs (20) das Bilden einer vorderen dielektrischen Schicht (20) aus thermischem Oxid umfasst, die oberhalb des aufgehängten Halbleiterbereichs (16;416) angeordnet ist.

9. Herstellungsverfahren nach einem der Ansprüche 6 bis 8, wobei das Bilden eines feststehenden Körpers (12) das Bilden eines Halbleiterkörpers (12) umfasst, der durch eine vordere Oberfläche (S_{front}) und eine untere Oberfläche (S_{bot}) begrenzt ist; wobei das Herstellungsverfahren ferner Folgendes umfasst:
- Bilden des Hohlraums (13), so dass er in dem Halbleiterkörper vergraben ist;
- Bilden mindestens einer Öffnung (19;219), die sich in den Halbleiterkörper erstreckt, zwischen dem Hohlraum und einer der vorderen Oberfläche und der unteren Oberfläche; und
- Durchführen eines thermischen Oxidationsprozesses, um den Hohlraum mit einer inneren dielektrischen Schicht (30) aus thermischem Oxid zu beschichten, die den Kompensationsbereich (31) bildet;
und wobei das Bilden der aufgehängten Struktur das Lösen der aufgehängten Struktur nach der Bildung der inneren dielektrischen Schicht umfasst.

10. Herstellungsverfahren nach Anspruch 9, wenn von Anspruch 8 abhängig, umfassend das Bilden der vorderen dielektrischen Schicht (20) durch den thermischen Oxidationsprozess.

11. Herstellungsverfahren nach Anspruch 9 oder 10, das durch den thermischen Oxidationsprozess Folgendes umfasst:
- Erhöhen der Dicke der inneren dielektrischen Schicht (30); und
- Bewirken der Bildung eines Abschlussbereichs (46;246) aus thermischem Oxid, der die Öffnung (19;219) verschließt und den Hohlraum (13) abdichtet, so dass die Zunahme der Dicke der inneren dielektrischen Schicht (30) vor dem Ende des thermischen Oxidationsprozesses gestoppt wird, so dass die Dicke der inneren dielektrischen Schicht (30) von der Form der Öffnung abhängt.

12. Herstellungsverfahren nach einem der Ansprüche 9 bis 11, wobei das Bilden von mindestens einer Öffnung (19;219) das Bilden, nach dem Bilden des Hohlraums (13) und vor dem Durchführen des thermischen Oxidationsprozesses, einer Vielzahl von Öffnungen (319) umfasst, die sich zwischen dem Hohlraum (13) und der unteren Oberfläche (S_{bot}) erstrecken, so dass die Öffnungen eine Vielzahl von halbleitenden Säulenbereichen (320) begrenzen; und wobei die Ausführung des thermischen Oxidationsprozesses in jeder Öffnung (319) die Bildung eines entsprechenden Abschlussbereichs (346) aus thermischem Oxid bewirkt, um den Hohlraum abzudichten; wobei das Herstellungsverfahren ferner Folgendes umfasst:
- selektives Entfernen der Abschlussbereiche; und
- Durchführen einer thermischen Behandlung, um die Bildung eines zusätzlichen Hohlraums (333), der vom vergrabenen Typ ist und sich zwischen dem Hohlraum und der unteren Oberfläche (S_{bot}) erstreckt, aus den halbleitenden Säulenbereichen (320) zu bewirken.

13. Herstellungsverfahren nach einem der Ansprüche 6 bis 8, wobei das Bilden eines feststehenden Körpers (12) das Bilden einer Struktur (400) umfasst, die eine Isolierschicht (414) und ein oberes Halbleiterbubstrat (410) und ein unteres Halbleitersubstrat (412) umfasst, die durch Einfügung der Isolierschicht gekoppelt sind; das Herstellungsverfahren ferner Folgendes umfasst:
- Bilden des Hohlraums (413), so dass er nach oben durch einen Teil (416') des oberen Halbleitersubstrats begrenzt ist und seitlich durch Abschnitte der Isolierschicht und des unteren Halbleitersubstrats begrenzt ist;
- Bilden eines Grabens (19), der sich durch den Teil des oberen Halbleitersubstrats erstreckt; und
- Durchführen eines thermischen Oxidationsprozesses, um den Hohlraum mit einer inneren dielektrischen Schicht (30) aus thermischem Oxid zu beschichten, die den Kompensationsbereich (31) bildet.

## Revendications

1. Dispositif MEMS comprenant :
- un corps fixe (14 ; 400) délimitant une cavité (13 ; 413) ;
- une structure suspendue (27 ; 427) s'étendant en porte-à-faux depuis le corps fixe, au-dessus de la cavité, et comprenant une région semiconductrice suspendue (16 ; 416) ; et
- un transducteur (40) placé au-dessus de la structure suspendue ;
et dans lequel la structure suspendue comprend en outre une région de compensation (31), qui s'étend sous la région semiconductrice suspendue ; le dispositif MEMS (10) étant **caractérisé en ce que** la région de compensation (31) est faite d'un oxyde thermique.

2. Dispositif MEMS selon la revendication 1, comprenant en outre au moins une région en compression (20) placée au-dessus de la région semiconductrice suspendue (16 ; 416).

3. Dispositif MEMS selon la revendication 2, dans lequel la région en compression (20) comprend une couche diélectrique avant (20) faite d'un oxyde thermique, placée au-dessus de la région semiconductrice suspendue (16 ; 416).

4. Dispositif MEMS selon la revendication 3, dans lequel la couche diélectrique avant (20) est en contact avec la région semiconductrice suspendue (16 ; 416), et dans lequel le transducteur (40) est placé au-dessus de la couche diélectrique avant.

5. Dispositif MEMS selon l'une quelconque des revendications précédentes, comprenant une couche diélectrique interne (30) faite d'un oxyde thermique, qui recouvre la cavité (13) et forme la région de compensation (31).

6. Procédé de fabrication d'un dispositif MEMS (10 ; 430), comprenant les étapes suivantes :
- former un corps fixe (14 ; 400) délimitant une cavité (13 ; 413) ;
- former une structure suspendue (27 ; 427) s'étendant en porte-à-faux depuis le corps fixe, au-dessus de la cavité, et comprenant une région semiconductrice suspendue (16 ; 416) ; et
- former un transducteur (40) placé au-dessus de la structure suspendue ;
et dans lequel la formation de la structure suspendue comprend la formation d'une région de compensation (31), qui s'étend sous la région semiconductrice suspendue ; le procédé de fabrication étant **caractérisé en ce que** la région de compensation (31) est faite d'un oxyde thermique.

7. Procédé de fabrication selon la revendication 6, comprenant la formation d'au moins une région en compression (20) placée au-dessus de la région semiconductrice suspendue (16 ; 416).

8. Procédé de fabrication selon la revendication 7, dans lequel la formation d'au moins une région en compression (20) comprend le fait de former une couche diélectrique avant (20) faite d'un oxyde thermique, placée au-dessus de la région semiconductrice suspendue (16 ; 416).

9. Procédé de fabrication selon l'une quelconque des revendications 6 à 8, dans lequel la formation d'un corps fixe (12) comprend le fait de former un corps semiconducteur (12) délimité par une surface avant (S_{front}) et une surface inférieure (S_{bot}) ; ledit procédé de fabrication comprenant en outre les étapes suivantes :
- former la cavité (13) de telle manière qu'elle est enfouie dans le corps semiconducteur ;
- former au moins une ouverture (19 ; 219) qui s'étend dans le corps semiconducteur, entre la cavité et une surface parmi la surface avant et la surface inférieure ; et
- exécuter un procédé d'oxydation thermique, afin de couvrir la cavité d'une couche diélectrique interne (30) faite d'un oxyde thermique, qui forme la région de compensation (31) ;
et dans lequel la formation de la structure suspendue comprend la libération de la structure suspendue suite à la formation de la couche diélectrique interne.

10. Procédé de fabrication selon la revendication 9 lorsqu'elle dépend de la revendication 8, comprenant le fait de former la couche diélectrique avant (20) au moyen dudit procédé d'oxydation thermique.

11. Procédé de fabrication selon la revendication 9 ou 10, comprenant les étapes suivantes, réalisées par le procédé d'oxydation thermique :
- augmenter l'épaisseur de la couche diélectrique interne (30) ; et
- provoquer la formation d'une région de fermeture (46 ; 246) faite d'un oxyde thermique qui ferme l'ouverture (19 ; 219), en rendant la cavité (13) hermétique, afin d'arrêter l'augmentation de l'épaisseur de la couche diélectrique interne (30) avant la fin du procédé d'oxydation thermique, de telle manière que l'épaisseur de la couche diélectrique interne (30) dépend de la forme de l'ouverture.

12. Procédé de fabrication selon l'une quelconque des revendications 9 à 11, dans lequel la formation d'au moins une ouverture (19 ; 219) comprend le fait de former, après la formation de la cavité (13) et avant l'exécution du procédé d'oxydation thermique, une pluralité d'ouvertures (319) qui s'étendent entre la cavité (13) et la surface inférieure (S_{bot}), de telle manière que les ouvertures délimitent une pluralité de régions semiconductrices verticales (320) ; et dans lequel l'exécution du procédé d'oxydation thermique provoque la formation, dans chaque ouverture (319), d'une région de fermeture correspondante (346) faite d'un oxyde thermique, afin de rendre la cavité hermétique ; ledit procédé de fabrication comprenant en outre les étapes suivantes :
- supprimer de manière sélective les régions de fermeture ; et
- réaliser un traitement thermique afin de provoquer la formation, depuis les régions semiconductrices verticales (320), d'une cavité supplémentaire (333), qui est du type enfoui et qui s'étend entre la cavité et la surface inférieure (S_{bot}).

13. Procédé de fabrication selon l'une quelconque des revendications 6 à 8, dans lequel la formation d'un corps fixe (12) comprend le fait de former une structure (400) comprenant une couche isolante (414) et un substrat semiconducteur supérieur (410) et un substrat semiconducteur inférieur (412), qui sont accouplés par interposition de la couche isolante ; ledit procédé de fabrication comprenant en outre les étapes suivantes :
- former la cavité (413) de manière telle qu'elle est délimitée vers le haut par une partie (416') du substrat semiconducteur supérieur et est délimitée latéralement par des parties de la couche isolante et du substrat semiconducteur inférieur ;
- former une tranchée (19) qui traverse la partie du substrat semiconducteur supérieur ; et
- exécuter un procédé d'oxydation thermique, afin de couvrir la cavité d'une couche diélectrique interne (30) faite d'un oxyde thermique, qui forme la région de compensation (31).
